# EUROPÄISCHE PATENTSCHRIFT

(11) **EP 1 769 535 B1**
(45) Veröffentlichungstag und Bekanntmachung des Hinweises auf die Patenterteilung: **27.02.2013**
(21) Anmeldenummer: 05749326.4
(22) Anmeldetag: 31.05.2005
(51) Int. Cl.: H01L 27/08, H01L 27/02

(54) **VORRICHTUNG FÜR EINE PASSIVE STABILISIERUNG VON VERSORGUNGSSPANNUNGEN EINES HALBLEITERBAUELEMENTS**
DEVICE FOR PASSIVE STABILIZATION OF SEMICONDUCTOR-ELEMENT SUPPLY VOLTAGES
DISPOSITIF PERMETTANT LA STABILISATION PASSIVE DE TENSIONS D'ALIMENTATION D'UN COMPOSANT A SEMI-CONDUCTEUR

(30) Priorität: 07.07.2004 DE 102004032708
(43) Veröffentlichungstag der Anmeldung: 04.04.2007
(73) Patentinhaber: ROBERT BOSCH GMBH, 70442 Stuttgart (DE)
(72) Erfinder: MAROLT, Vinko, 72768 Reutlingen (DE); STEPHAN, Ralf-Eckhard, 73765 Neuhausen A.D. Fildern (DE)
(86) Internationale Anmeldenummer: PCT/EP2005/052472
(87) Internationale Veröffentlichungsnummer: WO 2006/003062

(56) Entgegenhaltungen:
- US-A- 5 631 492
- US-B1- 6 434 730
- US-B1- 6 541 840
- PATENT ABSTRACTS OF JAPAN Bd. 009, Nr. 043 (E-298), 22. Februar 1985 (1985-02-22) & JP 59 182553 A (HITACHI MAIKURO COMPUTER ENGINEERING KK; others: 01), 17. Oktober 1984 (1984-10-17)

## Beschreibung

Die vorliegende Erfindung betrifft eine Vorrichtung für eine passive Stabilisierung von Spannungsversorgungen eines Halbleiterbauelements.

### STAND DER TECHNIK

Obwohl prinzipiell auf beliebig integrierte Schaltungen mit getrennten Verdrahtungsbereichen anwendbar, wird die vorliegende Erfindung in Bezug auf integrierte digitale Schaltungen erläutert.

Aus Kostengründen werden in einer heute üblichen Herstellungstechnik digitaler Schaltungen einzelne Arbeitsschritte der Entwicklung und des Designs der digitalen Schaltungen automatisiert. In einem ersten Schritt wird die Funktion und der schaltungstechnische Aufbau abstrakt formuliert. Die abstrakte Formulierung der Schaltung wird in weiteren Schritten unter Verwendung von Bibliotheken in eine physische Ausprägung übertragen. Die Bibliotheken umfassen dafür physische Repräsentationen häufig wiederkehrender Teilschaltungen der abstrakten Schaltungen. Eine grundlegende Teilschaltung ist eine Standardzelle. Eine typische Standardzelle umfasst zwei komplementäre Transistoren, welche in einer "Push-Pull"-Konfiguration angeordnet sind. Die Transistoren können in CMOS-Technologie oder in bipolarer Technologie ausgeprägt sein. Die Versorgung der Standardzelle erfolgt über eine Spannungsquelle und eine der Spannungsquelle zugehörigen Masse.

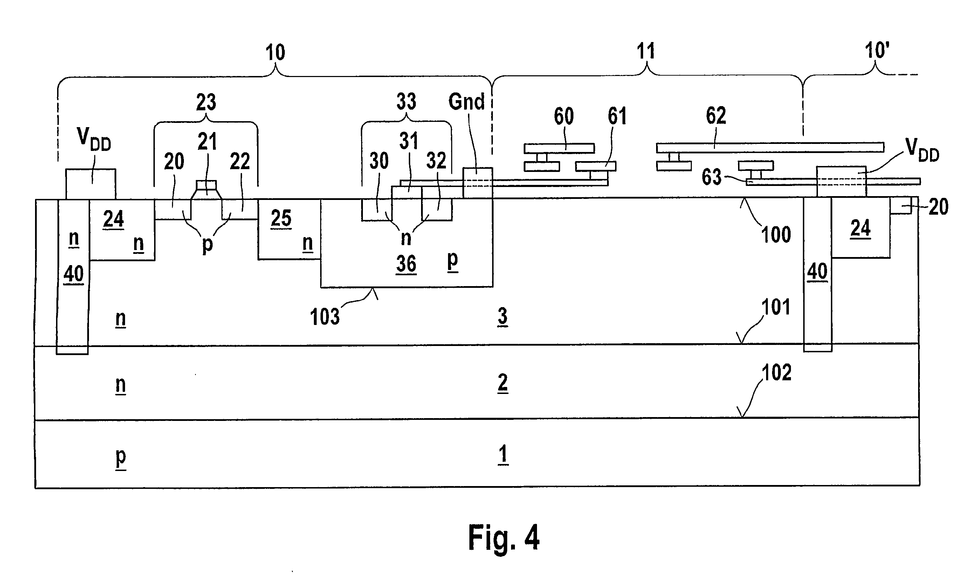

In Figur 4 ist ein typischer Aufbau einer solchen Standardzelle 10 gezeigt. Die beiden komplementären Transistoren, ein n-Kanaltyp 23 und ein p-Kanaltyp 33 sind dargestellt. In einer Bibliothek sind typischerweise die Platzierungen, die Abmessungen und Dotierungen der einzelnen benötigten Strukturen vorgegeben. Die dargestellte Ausprägung der Standardzelle der Bibliothek sieht vor für einen n-Kanal Transistor 23 in CMOS-Technologie zwei p-dotierte Bereiche 20 und 22 in eine n-dotierte erste Halbleiterschicht 3 einzuprägen und eine Gate-Struktur 21 auf die oberste Fläche 100 der n-dotierten ersten Schicht 3 aufzubringen. Des Weiteren sind zwei n-dotierte Bereiche 24 und 25 vorgesehen, welche den n-Kanal Transistor flankieren. Angrenzend an den n-dotierten Bereich 25 ist eine p-dotierte Wanne 36 in die n-dotierte erste Schicht 3 eingebracht In diese p-dotierte Wanne werden zwei n-dotierte Bereiche 30 und 32 eingebracht, welche Drain und Source des p-Kanal Transistors bilden. Des weiteren wird eine Gate-Struktur 31 auf die oberste Fläche 100 zwischen den beiden n-dotierten Bereichen 30 und 32 aufgebracht. Des weiteren ist in der Bibliothek vorgesehen die positive Stromversorgung V_{DD} mit dem n-dotierten Bereich 24 in Kontakt zu bringen, sowie eine Masseverbindung Gnd mit der p-dotierten Wanne zu kontaktierten.

Die einzelnen Standardzellen 10 werden durch Verdrahtungen 60-63 miteinander verknüpft, so dass die gewünschte Funktionalität der Schaltung erreicht wird. Die Führung der Verdrahtungen 60 bis 63 erfolgt sowohl über den verwendeten Standardzellen als auch in von den Standardzellen 10 lateral räumlich getrennten Bereichen 11. Über den Standardzellen können jedoch nur die Verdrahtungen verwendet werden, die nicht durch Strukturen innerhalb der Standardzellen blockiert werden, während in den räumlich getrennten Gebieten alle Verdrahtungsebenen uneingeschränkt verwendet werden können.

Bei jedem Schaltvorgang einer Standardzelle 10 fließt kurzzeitig ein erhöhter Strom zwischen V_{DD} und der Masse Gnd. Dieser erhöhte Strom ist Folge eines Querstroms, welcher durch gleichzeitiges Schalten des N-Kanal-Transistors 23 und des P-Kanal-Transistors 33 in den leitenden bzw. gesperrten Zustand entsteht und/oder durch das Umladen von parasitären Kondensatoren in der Standardzelle 10. Dieser Strom muss durch die Spannungsversorgung V_{DD} zur Verfügung gestellt werden, und über die Masseverbindung Gnd abfließen können. Da sowohl die Zuleitungen der Spannungsversorgung als auch der Masse eine Induktivität aufweisen, entsteht ein Spannungspuls in den Versorgungsleitungen, wenn der Stromfluss durch eine Standardzelle 10 zu- oder abnimmt. Das bedeutet, dass bei jedem Schalten einer Standardzelle 10 eine Spannungsspitze in den Versorgungsleitungen entsteht. Da in digitalen Schaltungen typischerweise viele Standardzellen 10 synchron zueinander geschalten werden, ergeben sich Spannungsspitzen großer Amplitude auf den Versorgungsleitungen. Die Schaltungen müssen so ausgelegt werden, dass die Spannungsspitzen unterhalb eines kritischen Wertes bleiben, bei dem sie die Funktionalität der Schaltung nicht negativ beeinflussen. Zur Begrenzung der Spannungsspitzen unter einen kritischen Wert sind mehrere Vorrichtungen bekannt.

Großflächige Versorgungsleitungen verringern aufgrund ihrer geringeren Induktivität die Höhe der Spannungsspitzen. Der vergrößerte Flächenbedarf ist jedoch nachteilig hinsichtlich der gewünschten höheren Integrationsdichte der Bauelemente.

Zusätzliche Kondensatoren, so genannte Stützkapazitäten, werden an die Versorgungsleitungen V_{DD} und die Masseleitungen Gnd angeschlossen. In einer herkömmlichen Technik werden diese außerhalb eines ICs oder Bauelements möglichst in der Nähe der Versorgungsleitung bzw. der Masseleitungen platziert. Aus Kostengründen ist jedoch ein Anbringen weiterer Bauelemente unerwünscht, des weiteren wird dadurch die erreichbare Integrationsdichte auf einer Leiterplatte reduziert.

Kondensatoren lassen sich innerhalb eines ICs in der Nähe der die Spannungsspitzen verursachenden Bauelemente integrieren. Die Herstellung dieser Stützkapazitäten erfordert eigene Prozessierungsschritte, was deshalb zu einer Verteuerung des ICs führt. Versucht man diesen Nachteil zu umgehen, indem keine zusätzlichen Prozessschritte gestattet werden, muss für die Kondensatoren innerhalb des ICs zusätzlicher Platz zur Verfügung gestellt werden. Dies verringert wiederum die mögliche Integrationsdichte und führt seinerseits zu einer Verteuerung des ICs.

Des Weiteren ist bekannt, dass an einer Grenzfläche 102 (vgl. Figur 4) zwischen einem p-dotierten Substrat 1 und einer stark n-dotierten vergrabenen Schicht 2 eine Sperrschichtkapazität entsteht. Diese Sperrschichtkapazität wird durch eine vertikale Verbindung 40 aus einem n-dotierten Material mit der positiven Spannungsversorgung V_{DD} verbunden. Aufgrund der geringen Länge der Verbindung 40, weist diese eine geringe Induktivität auf. Des weiteren ist die Kapazität der Sperrschicht aufgrund der großen Grenzfläche 102 groß. Aufgrund der beiden genannten Punkte wird eine effektive Unterdrückung der Spannungsspitzen auf der positiven Spannungsversorgung V_{DD} erreicht. Nachteilig ist, dass auf diese Weise nur eine Stützung der positiven Spannungsversorgung erreicht wird. Der für die Gleichspannungsanteile der positiven Spannungsversorgung V_{DD} sperrende NP-Übergang der n-dotierten vergrabenen Schicht 2 zum p-dotierten Substrat, ist auf Grund der Polarität der Masse leitend. Eine Anbindung der Masse an die vergrabene n-dotierte Schicht und die Kapazität der Grenzschicht 102 ist daher nicht möglich.

US 6 541 840 B1 zeigt einen IC-integrierten Kondensator, wobei eine p-Wanne in einer n-Schicht mit einem p-Substrat verbunden ist.

Die Aufgabe der vorliegenden Erfindung besteht darin, eine zusätzliche Stützkapazität innerhalb eines Halbleiterbauelements zu implementieren, welches sich ohne zusätzlichen lateralen Platzbedarf mit herkömmlichen Herstellungsverfahren integrieren lässt.

Erfindungsgemäß wird diese Aufgabe durch die in Anspruch 1 angegebene Vorrichtung gelöst.

### VORTEILE DER ERFINDUNG

Die Vorteile der erfindungsgemäßen Vorrichtung liegen insbesondere darin, dass eine Stabilisierung der Masseversorgung und/oder der Spannungsversorgung von Standardzellen eines Halbleiterbauelements erreicht werden. Das Halbleiterbauelement weist in einem ersten lateralen Bereich Standardzellen mit aktiven Bauelementen auf, welcher abgegrenzt zu einem zweiten lateralen Bereich ist, in welchem die Standardzellen miteinander verdrahtet werden. Eine Standardzelle weist mindestens einen Transistor eines ersten typs und mindestens einen Transistor eines zweiten Leitfähigkeitstyps auf. Die Leit fähigkeits Standardzelle weist einen ersten Kontakt auf, welcher mit einer Polarität einer Spannungsversorgung verbunden ist Dieser erste Kontakt steht in leitender Verbindung zu einer ersten Schicht eines ersten Leitfähigkeitstyps auf einem Halbleitersubstrat, in welche mindestens einer der Transistoren des ersten Leitfähigkeitstyps eingebracht ist. An einem zweiten Kontakt der Standardzelle liegt eine zweite Polarität der Spannungsversorgung an. Dieser Kontakt ist in leitender Verbindung zu einer Wanne, welche ein Halbleitermaterial eines zweiten Leitfähigkeitstyps aufweist. In dieser Wanne ist mindestens ein Transistor des zweiten Leitfähigkeitstyps eingebracht. Unmittelbar zwischen der ersten Schicht und dem Substrat, welches aus Halbleitermaterial eines zweiten Leitfähigkeitstyps ist, ist eine vergrabene Schicht eingebracht, welche den ersten Leitfähigkeitstyp aufweist. In zweiten lateralen Bereichen erfolgt die Verdrahtung der Standardzellen. In die erste Schicht innerhalb des zweiten lateralen Bereichs werden erste und zweite Stabilisierungsbereiche eingebracht, welche den zweiten Leitfähigkeitstyp aufweisen. Die ersten Stabilisierungsbereiche grenzen unmittelbar an die Wanne mit dem zweiten Leitfähigkeitstyp an. Die Sperrschichtkapazität, welche sich zwischen den ersten Stabilisierungsbereichen und der ersten Schicht ausbildet, addiert sich zu der Sperrschichtkapazität zwischen der Wanne und der ersten Schicht. Die zweiten Stabilisierungsbereiche sind über eine vertikale Verbindung des zweiten Leitfähigkeitstyps mit dem Substrat verbunden und stehen nicht in Kontakt mit der Wanne. Die Kapazität der Sperrschicht zwischen den zweiten Stabilisierungsbereichen und der ersten Schicht ist mit dem großen Ladungsreservoir und dem damit einhergehenden stabilen Potenzial des Substrats 1 verbunden und stabilisiert dadurch das Potenzial der ersten Schicht 3.

In den Unteransprüchen finden sich vorteilhafte Weiterbildungen und Verbesserungen der in Anspruch 1 angegebenen Vorrichtung.

Eine erfindungsgemäße Weiterbildung sieht vor, dass die ersten Stabilisierungsbereiche und/oder die zweiten Stabilisierungsbereiche eine große Oberfläche aufweisen. Mit einer großen Oberfläche wird eine große Sperrschichtkapazität erreicht und damit eine gute Stabilisierung der Spannungsversorgungen.

Eine erfindungsgemäße Weiterbildung sieht vor, die ersten Stabilisierungsbereiche und/oder die zweiten Stabilisierungsbereiche mit einer Vielzahl an Lamellen auszustatten. Die Lamellen lassen sich in herkömmlichen Strukturierungstechniken herstellen und erhöhen vorteilhafter Weise die Oberfläche der Stabilisierungsbereiche.

Eine erfindungsgemäße Weiterbildung sieht vor, die Stabilisierungsbereiche in der ersten Schicht zu vergraben. Dies erhöht einerseits die Oberfläche der Stabilisierungsbereiche, andererseits lassen sich kapazitative Einflüsse zwischen den Verdrahtungen und den Sperrschichtkapazitäten durch die erhöhte Distanz verringern.

Eine weitere erfindungsgemäße Weiterbildung sieht vor, mindestens einen der Stabilisierungsbereiche unmittelbar mit einem dritten Kontakt zu verbinden, an welchem die zweite Polarität der Spannungsversorgung anliegt

Die Kapazität einer Sperrschicht steigt mit der Dotiermittelkonzentration der Stabilisierungsbereiche. Daher sieht eine weitere erfindungsgemäße Weiterbildung eine hohe Dotiermittelkonzentration in den Stabilisierungsbereichen vor.

Eine weitere erfindungsgemäße Weiterbildung sieht vor, dass die erste Polarität der Spannungsversorgung positiv ist und die zweite Polarität die Masse darstellt

Ausführungsbeispiele der Erfindung sind in den Zeichnungen dargestellt und in der nachfolgenden Beschreibung näher erläutert.

### ZEICHNUNGEN

Es zeigen:
Figur 1 eine schematische Darstellung eines Teilschnitts eines Beispiels;
Figur 2 eine schematische Darstellung eines Teilschnitts eines weiteren Beispiels;
Figur 3 eine schematische Darstellung eines Teilschnitts einer Ausführungsform der vorliegenden Erfindung; und
Figur 4 eine schematische Darstellung zur Erläuterung der vorliegenden Problematik.

In den Figuren bezeichnen gleiche Bezugszeichen gleiche oder funktionsgleiche Bestandteile.

### BESCHREIBUNGEN DER AUSFÜHRUNGSBEISPIELE

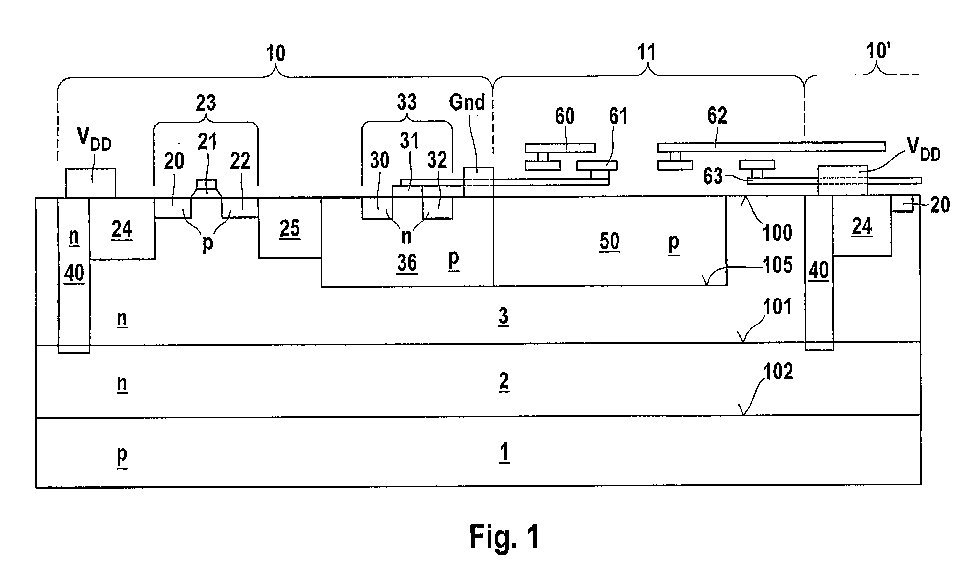

Figur 1 zeigt eine schematische Darstellung eines Teilschnitts eines nicht beanspruchten Beipiels. Figur 1 zeigt ein p-dotiertes Substrat 1. Auf das Substrat 1 ist eine n-dotierte Schicht 2 auf die Fläche 102 aufgebracht. Die Schicht 2 wird nachfolgend als vergrabene Schicht bezeichnet ("burried layer"). Auf die vergrabene Schicht 2 ist eine n-dotierte erste Schicht 3 aufgebracht. In die vom Substrat 1 abgewandte obere Fläche 100 der ersten Schicht 3 sind mehrere Strukturen eingebracht. Die Strukturen lassen sich nach ihrer Funktion in zwei Typen unterteilen: Standardzellen 10 und Verdrahtungskanäle 11. Die Standardzellen 10 werden typischerweise längs einer lateralen Richtung angeordnet. Parallel zu einer Reihe an Standardzellen 10 verlaufen typischerweise weitere Standardzellen 10'. In der Darstellung der Figur 1 entspricht diese laterale Richtung einer Richtung senkrecht zur Blattebene. Die Verdrahtung 60-63 der Standardzellen 10 erfolgt vorwiegend in den Verdrahtungskanälen 11, welche lateral von den Standardzellen abgegrenzt sind. Die Verdrahtungen verlaufen oberhalb der oberen Fläche 100 der ersten Schicht 3. Die Anordnung der Standardzellen 10 in Reihen ist exemplarisch. Jegliche laterale Anordnung ist denkbar, entscheidend ist nur, dass die Verdrahtungskanäle 11 räumlich von den Standardzellen 10 abgegrenzt sind.

Eine Standardzelle 10 der dargestellten Ausführungsform besteht aus einem n-Kanal-MOSFET 23 und einem p-Kanal-MOSFET 33, einer positiven Spannungsversorgung V_{DD} und einer Masse Gnd. Der n-Kanal-MOSFET 23 ist aus zwei p-dotierten Bereichen 20, 22 aufgebaut, welche in die obere Fläche 100 der n-dotierten Schicht 3 eingebracht sind, wobei über einen Bereich zwischen den beiden p-dotierten Bereichen 20 und 22 eine Gate-Struktur 21 aufgebracht ist. Des weiteren sind noch zwei n-dotierte Bereiche 24 und 25 in das n-dotierte Substrat 3 eingebracht, welche in lateraler Richtung an die p-dotierten Bereiche 20 und 22 angrenzen. Um einen p-Kanal-MOSFET bestehend aus zwei n-dotierten Bereichen 30 und 32, sowie einen Gate-Bereich 31, welcher sich oberhalb des Bereichs zwischen den beiden n-dotierten Bereichen 30 und 32 befindet, herzustellen, wird in einem ersten Schritt in die n-dotierte Schicht 3 eine p-dotierte Wanne 36 eingebracht. In diese werden die n-dotierten Bereiche 30 und 32 eingebracht, wobei dann zwischen den n-dotierten Bereichen p-dotiertes Material ist.

An einem Kontaktbereich, welcher an der Oberfläche 100 angebracht ist und in leitender Verbindung mit dem n-dotierten Bereich 24 ist, erfolgt die Spannungsversorgung V_{DD}. Die Anbindung an die Masse erfolgt durch einen zweiten Kontakt, welcher ebenfalls auf die Oberfläche 100 aufgebracht ist und die p-dotierte Wanne 36 berührt.

Der Kontaktbereich der Spannungsversorgung V_{DD} ist durch eine vertikale n-dotierte Verbindung 40 ("Sinker") mit einer vergrabenen stark n-dotierten Schicht 2 verbunden, welche an die n-dotierte Schicht 3 an die von der oberen Fläche 100 abgewandte Fläche 101 angrenzt. Die vergrabene Schicht 2 weist eine Grenzfläche mit einem p-dotiertes Substrat 1 auf. An dieser Grenzfläche bildet sich eine Sperrschicht 102 aus. Die Sperrschicht 102 weist eine Kapazität auf, welche proportional der Fläche der Sperrschicht 102 ist Die n-dotierte Fläche der Kapazität der Sperrschicht 102 wird durch die vertikale Verbindung 40 mit der Spannungsversorgung V_{DD} verbunden. Die vertikale Verbindung 40 ist derart herzustellen, dass sie eine hohe Leitfähigkeit und geringen Induktivität aufweist. Dies ermöglicht eine Stabilisierung der positiven Spannungsversorgung V_{DD}.

Zwischen der Grenzfläche der p-dotierten Wanne 36 und der n-dotierten Schicht 3 bildet sich eine zweite Sperrschicht 103. Die umgekehrte Polarität der zweiten Sperrschicht ermöglicht diese für die Stabilisierung der Masseversorgung Gnd zu benutzen. Nachteilig ist jedoch, dass die Oberfläche der zweiten Sperrschicht 103 gering ist. Die Oberfläche ist begrenzt durch die Abmessungen der p-dotierten Wanne 36.

Der Aufbau der Standardzellen 10 soll möglichst kompakt sein, um viele Standardzellen 10 in einem Bauelement auf möglichst geringer Fläche unterzubringen. Daher wird der p-Kanal-MOSFET so aufgebaut, dass er eine möglichst geringe Fläche einnimmt, d.h. in den Bibliotheken weist die p-dotierte Wanne 36 die minimal mögliche Abmessungen auf, welche notwendig ist, um einen p-Kanal-MOSFET zu realisieren. Eine Vergrößerung der p-dotierten Wanne 36, um eine größere Sperrschicht 103 zu erreichen, würde die lateralen Abmessungen jeder Standardzelle 10 erhöhen. Der erhöhte Platzbedarf ist jedoch nicht erwünscht.

Es wird angrenzend an den Bereich 36 ein weiterer p-dotierter Bereich 50 in die n-dotierte Schicht 3 eingebracht. Dieser Bereich wird nachfolgend als Stabilisierungsbereich bezeichnet. Vorteilhafterweise befindet sich der Stabilisierungsbereich 50 unterhalb des Verdrahtungskanals 11. Typischerweise befinden sich unterhalb des Verdrahtungskanals 11 keinerlei Strukturierung der n-dotierten Schicht 3. Durch den Kontakt des Stabilisierungsbereiches 50 mit der p-dotierten Wanne 36 vergrößert sich die Sperrschicht 103 um die Sperrschicht 105. Dies hat zur Folge, dass die Kapazität der Sperrschicht sich erhöht und damit eine bessere Stabilisierung der Massenversorgung Gnd ermöglicht wird.

Das Einbringen des Stabilisierungsbereiches 50 unterhalb des Verdrahtungskanals 11 ist nicht mit einer unmittelbaren Vergrößerung der Wanne 36 gleichzusetzen. Der wesentliche Vorteil liegt darin, dass für die typischerweise verwendeten Verfahren des Designs mit Bibliotheken von Schaltungen, der Aufbau der Standardzellen nicht geändert wird und diese somit ihre minimalen Abmessungen beibehalten. Des weiteren erfordert das Einbringen des Stabilisierungsbereiches 50 unterhalb des Verdrahtungskanals 11 keine Änderung der Design-Verfahren für die Verdrahtungen 60-63. Dies ist u.a. darin begründet, dass unterhalb des Verdrahtungskanals 11 bisher keinerlei Strukturen in die erste Schicht 3 eingebracht wurden. Der Entwurf der p-dotierten Stabilisierungsbereiche 50 ist somit kompatibel mit den typischen Verfahrensschritten der Halbleitertechnologie und lässt sich in diese integrieren.

Da entscheidend für die Kapazität der Sperrschicht 105 die Oberfläche der Sperrschicht 105 ist, kann der p-dotierte Stabilisierungsbereich 50 lateral und/oder vertikal strukturiert sein. Vorteilhafterweise ist die Gestaltung derart, dass die Oberfläche des p-dotierten Stabilisierungsbereichs 50 eine möglichst große Oberfläche aufweist und dennoch einen zusammenhängenden Bereich bildet. Eine mögliche Gestaltung sieht vor, den p-dotierten Stabilisierungsbereich 50 mit vielen Lamellen zu versehen, welche die p-dotierte Wanne 36 berühren. Des Weiteren kann der p-dotierte Stabilisierungsbereich 50 in der n-dotierten Schicht 3 vergraben sein, wobei der p-dotierte Stabilisierungsbereich 50 die p-dotierte Wanne 36 berührt.

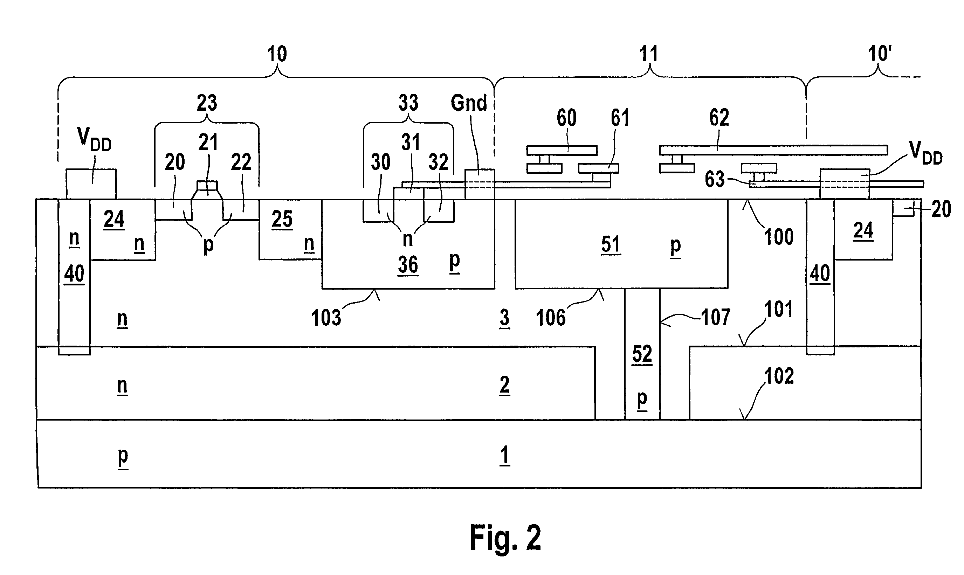

Figur 2 zeigt eine schematische Darstellung eines Teilschnitts eines weiteren Beipiels. Es weist wiederum Standardzellen 10 und Verdrahtungskanäle 11 auf. Unterhalb des Verdrahtungskanals 11 ist in dem n-dotierten Bereich 3 ein p-dotierter Stabilisierungsbereich 51 eingebracht. Dieser p-dotierte Stabilisierungsbereich 51 steht nicht in Kontakt mit der p-dotierten Wanne 36 des p-Kanal-MOSFETs 33. Durch eine vertikale p-dotierte Verbindung 52 ist der p-dotierte Stabilisierungsbereich 51 mit dem p-dotierten Substrat 1 verbunden. Zwischen dem p-dotierten Stabilisierungsbereich 51 und der n-dotierten Schicht 3 bildet sich eine Sperrschicht 106 aus. Die Kapazität der Sperrschicht koppelt das Potenzial des p-dotierten Substrats 1 kapazitiv an das Potenzial der n-dotierten ersten Schicht 3. Da das Substrat 1 ein großes Ladungsreservoir und ein stabiles Potenzial aufweist, wird auf diese Weise das Potenzial der ersten Schicht 3 stabilisiert. Die erste Schicht 3 wiederum steht in direktem Kontakt mit der Spannungsversorgung V_{DD} oder noch unmittelbarer mit dem n-Kanal-MOSFET, so dass Spannungsschwankungen der Versorgung V_{DD} reduziert werden. Auf diese Weise stabilisiert der p-dotierte Stabilisierungsbereich 51, welcher durch die vertikale Verbindung 52 mit dem Substrat 1 verbunden ist die positive Spannungsversorgung V_{DD}. Die Ausgestaltung des p-dotierten Stabilisierungsbereichs 51 kann, wie in Figur 2 dargestellt, eine Wanne sein, aber sowohl auch lateral wie vertikal strukturiert sein, um eine möglichst große Oberfläche der Sperrschicht 106 zu erreichen. Die vertikale p-dotierte Verbindung 52 bildet auch eine Sperrschicht 107 aus.

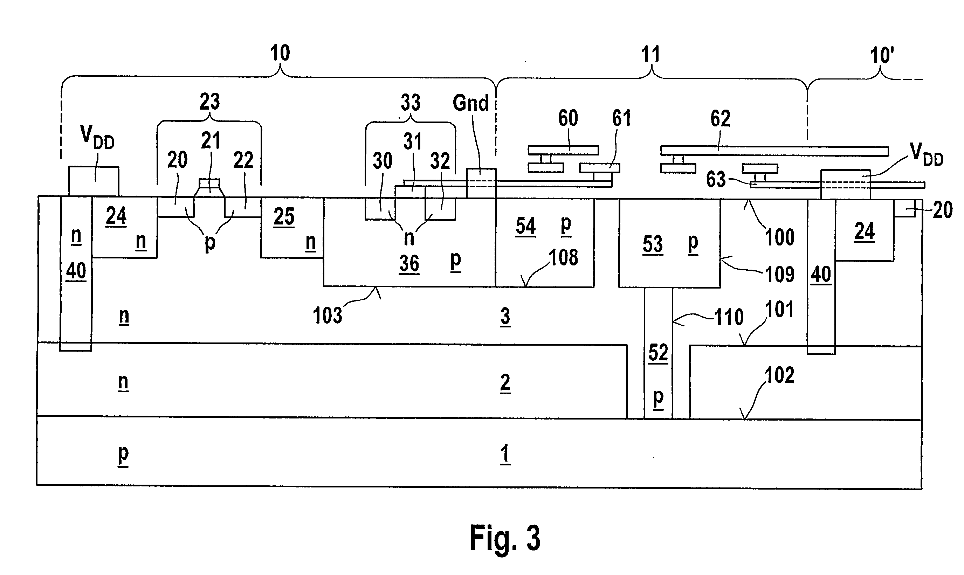

Figur 3 zeigt eine schematische Darstellung eines Teilschnitts einer Ausführungsform der vorliegenden Erfindung. Diese Ausführungsform weist einen p-dotierten Stabilisierungsbereich 54 auf, welcher an die p-dotierte Wanne 36 des p-Kanal-MOSFETs angrenzt Dieser p-dotierte Stabilisierungsbereich 54 ist wie zu Figur 1 beschrieben unterhalb der Verbindungen eingebracht. Dieser stützt wie zu Figur 1 beschrieben die Masseversorgung Gnd. Zusätzlich ist unterhalb der Verdrahtung 11 ein zweiter p-dotierter Stabilisierungsbereich 53 eingebracht, welcher durch eine p-dotierte vertikale Verbindung 52 mit dem p-dotierten Substrat 1 verbunden ist. Der p-dotierte Stabilisierungsbereich 53 stabilisiert wie zu Figur 2 beschrieben das Potenzial des n-dotierten Bereichs 3 und damit auch die Spannungsversorgung V_{DD}. Die Ausgestaltung des Bereichs der Schicht 3, welche sich unmittelbar unterhalb der Verdrahtung 11 befindet wird derart gestaltet, dass die Versorgung (Spannungsversorgung V_{DD}, Massenversorgung Gnd) stärker stabilisiert wird, indem der Stabilisierungsbereich 53 bzw. 54 entsprechend ein größeres Volumen einnimmt, je nach dem, welche der beiden Versogungen größeren Belastungen ausgesetzt ist.

Obwohl die Erfindung anhand einer bevorzugten Ausführungsform beschrieben wurde, ist sie darauf nicht beschränkt, sondern auf vielfältige Art und Weise modifizierbar.

Die Leitfähigkeitstypen der Schichten können von den jeweiligen anderen Leitfähigkeitstypen ersetzt werden. Hierbei ist unter Anderem denkbar negative Spannungsversorgung zu stützen.

Vor allem ist die Erfindung nicht auf Bauelemente mit Standardzellen aus zwei Transistoren beschränkt. Diese sind nur aus Gründen der einfacheren Darstellung gewählt Die Standardzellen können ebenso aus einer Vielzahl an Transistoren und/oder passiven Bauelementen aufgebaut sein.

### BEZUGSZEICHENLISTE

- 1: p-dotiertes Substrat
- 2: n-dotierte vergrabene Schicht
- 3: n-dotierte erste Schicht
- 10, 10': Standardzellen
- 11: Verdrahtungskanal
- 20, 22: p-dotierte Bereiche
- 21: Gate
- 23: n-Kanal Transistor
- 24, 25: n-dotierte Bereiche
- 30, 32: n-dotierte Bereiche
- 31: Gate
- 33: p-Kanal Transistor
- 36: p-dotierte Wanne
- 60-63: Verdrahtungen
- 40: vertikale Verbindung
- 52: vertikale Verbindung
- 50, 51, 53, 54: p-dotierte Stützbereiche
- 100: obere Grenzfläche
- 101: Grenzfläche
- 102, 103: Sperrschicht
- 105-110: Sperrschichten
- V_{DD}: positive Spannungsversorgung
- Gnd: Masseverbindung

## Patentansprüche

1. Halbleitervorrichtung mit einem Substrat (1) eines zweiten Leitfähigkeitstyps (p), einer ersten Schicht (3) des ersten Leitfähigkeitstyps (n), und einer unmittelbar zwischen der ersten Schicht (3) und dem Substrat (1) eingebrachten stark dotierten vergrabenen Schicht (2) eines ersten Leitfähigkeitstyps (n)
wobei in ersten lateralen Bereichen (10) Standardzellen mit aktiven Bauelementen angeordnet sind, wobei eine Standardzelle mindestens einen Transistor (33) des ersten Leitfähigkeitstyps (n) und mindestens einen Transistor (23) des zweiten Leitfähigkeitstyps (p) aufweist,
wobei der Transistor des zweiten Leitfähigkeitstyps (p) in die erste Schicht (3) eingebracht ist und der Transistor des ersten Leitfähigkeitstyps (n) in eine Wanne (36) aus einem Halbleitermaterial zweiten Leitfähigkeitstyps (p) eingebracht ist, wobei die Wanne (36) in die erste Schicht (3) eingebracht ist,
wobei die Standardzelle über eine Spannungsversorgung versorgt wird, wobei an einem ersten Kontakt, welcher leitend mit der ersten Schicht (3) verbunden ist, eine erste Polarität (V_{DD}) der Spannungsversorgung anliegt und an einem zweiten Kontakt, welcher leitend mit der Wanne (36) verbunden ist, die zweite Polarität (Gnd) anliegt,
wobei in zweiten lateralen Bereichen (11) Verdrahtungen (60, 61, 62) oberhalb der ersten Schicht (3) zum Verbinden der Standardzellen geführt werden und in den zweiten lateralen Bereichen (11) keine aktiven Bauelemente angeordnet sind,
wobei in der ersten Schicht (3) innerhalb der zweiten lateralen Bereiche (11) erste Stabilisierungsbereiche (50, 54) und zweite Stabilisierungsbereiche (51, 53) aus einem Halbleitermaterial zweiten Leitfähigkeitstyps eingebracht sind, wobei an Grenzflächen (105-110) zwischen den Stabilisierungsbereichen (50, 51, 53, 54) und der ersten Schicht (3) sich Sperrschichtkapazitäten ausbilden,
wobei die ersten Stabilisierungsbereiche (50, 54) unmittelbar an die Wanne (36) angrenzen und wobei die zweiten Stabilisierungsbereiche (51, 53) durch eine vertikale Verbindung (52) aus einem Halbleitermaterial zweiten Leitfähigkeitstyps (P) mit dem Substrat (1) verbunden sind, wobei die zweiten Stabilisierungsbereiche (53) nicht mit der Wanne (36) in Kontakt stehen.

2. Vorrichtung nach Anspruch 1, wobei die ersten Stabilisierungsbereiche (50, 54) und/oder die zweiten Stabilisierungsbereiche (51, 53) eine große Oberfläche aufweisen.

3. Vorrichtung nach Anspruch 2, wobei die ersten Stabilisierungsbereiche (50, 54) und/oder die zweiten Stabilisierungsbereiche (51, 53) eine Vielzahl an Lamellen aufweisen.

4. Vorrichtung nach einem der vorhergehenden Ansprüche, wobei die Stabilisierungsbereiche (50-54) in der ersten Schicht (3) vergraben sind.

5. Vorrichtung nach einem der vorhergehenden Ansprüche 1 bis 3, wobei die Stabilisierungsbereiche (50-54) unmittelbar mit einem dritten Kontakt verbunden sind, an welchem die zweite Polarität (Gnd) der Spannungsversorgung anliegt.

6. Vorrichtung nach einem der vorhergehenden Ansprüche, wobei wie Stabilisierungsbereiche (50-54) eine hohe Dotiermaterialkonzentration aufweisen.

7. Vorrichtung nach einem der vorhergehenden Ansprüche, wobei die erste Polarität der Spannungsversorgung (V_{DD}) ein positives Potential gegenüber der zweiten Polarität (Gnd) aufweist.

## Claims

1. Semiconductor device comprising a substrate (1) of a second conductivity type (p), a first layer (3) of a first conductivity type (n), and a severely doped, buried layer (2) of the first conductivity type (n) that is introduced directly between the first layer (3) and the substrate (1), wherein standard cells with active components are arranged in first lateral regions (10), wherein a standard cell has at least one transistor (33) of the first conductivity type (n) and at least one transistor (23) of the second conductivity type (p), wherein the transistor of the second conductivity type (p) is introduced into the first layer (3) and the transistor of the first conductivity type (n) is introduced into a trough (36) consisting of a semiconductor material of the second conductivity type (p), wherein the trough (36) is introduced into the first layer (3), wherein the standard cell is supplied via a voltage supply, wherein a first polarity (V_{DD}) of the voltage supply is present at a first contact, which is conductively connected to the first layer (3), and the second polarity (Gnd) is present at a second contact, which is conductively connected to the trough (36), wherein wirings (60, 61, 62) are guided above the first layer (3) for connecting the standard cells in second lateral regions (11), and no active components are arranged in the second lateral regions (11), wherein first stabilization regions (50, 54) and second stabilization regions (51, 53) consisting of a semiconductor material of the second conductivity type are introduced in the first layer (3) within the second lateral regions (11), wherein junction capacitances are formed at interfaces (105-110) between the stabilization regions (50, 51, 53, 54) and the first layer (3), wherein the first stabilization regions (50, 54) directly adjoin the trough (36), and wherein the second stabilization regions (51, 53) are connected to the substrate (1) by a vertical connection (52) consisting of a semiconductor material of the second conductivity type (p), wherein the second stabilization regions (53) are not in contact with the trough (36).

2. Device according to Claim 1, wherein the first stabilization regions (50, 54) and/or the second stabilization regions (51, 53) have a large surface area.

3. Device according to Claim 2, wherein the first stabilization regions (50, 54) and/or the second stabilization regions (51, 53) have a large number of laminations.

4. Device according to one of the preceding claims, wherein the stabilization regions (50-54) are buried in the first layer (3).

5. Device according to one of the preceding Claims 1 to 3, wherein the stabilization regions (50-54) are connected directly to a third contact, at which the second polarity (Gnd) of the voltage supply is present.

6. Device according to one of the preceding claims, wherein the stabilization regions (50-54) have a high doping material concentration.

7. Device according to one of the preceding claims, wherein the first polarity of the voltage supply (V_{DD}) has a positive potential with respect to the second polarity (Gnd).

## Revendications

1. Ensemble semi-conducteur présentant un substrat (1) d'un deuxième type de conductivité (p), une première couche (3) d'un premier type de conductivité (n) et une couche (2) du premier type de conductivité (n), enterrée et fortement dopée, ménagée directement entre la première couche (3) et le substrat (1),
des cellules standard à composants actifs étant disposées dans des premières parties latérales (10),
une cellule standard présentant au moins un transistor (33) du premier type de conductivité (n) et au moins un transistor (23) du deuxième type de conductivité (p),
le transistor du deuxième type de conductivité (p) étant placé dans la première couche (3) et le transistor du premier type de conductivité (n) étant placé dans une cuvette (36) en un matériau semi-conducteur du deuxième type de conductivité (p),
la cuvette (36) étant ménagée dans la première couche (3),
la cellule standard étant alimentée par une alimentation en tension,
une première polarité (V_{DD}) de l'alimentation en tension étant appliquée sur un premier contact relié de manière conductrice à la première couche (3) et la deuxième polarité (Gnd) étant appliquée sur un deuxième contact relié de manière conductrice à la cuvette (36),
des câblages (60, 61, 62) étant placés dans des deuxièmes parties latérales (11), au-dessus de la première couche (3), pour relier les cellules standard et aucun composant actif n'étant disposé dans les deuxièmes parties latérales (11),
des premières parties de stabilisation (50, 54) et des deuxièmes parties de stabilisation (51, 53) en un matériau semi-conducteur du deuxième type de conductivité étant ménagées dans la première couche (3) à l'intérieur des deuxièmes parties latérales (11),
des capacités de couche de barrière se formant aux surfaces frontières (105-110) entre les parties de stabilisation (50, 51, 53, 54) et la première couche (3),
les premières parties de stabilisation (50, 54) étant directement adjacentes à la cuvette (36),
les deuxièmes parties de stabilisation (51, 53) étant reliées au substrat (1) par une liaison verticale (52) en un matériau semi-conducteur du deuxième type de conductivité (p) et
les deuxièmes parties de stabilisation (53) n'étant pas en contact avec la cuvette (36).

2. Dispositif selon la revendication 1, dans lequel les premières parties de stabilisation (50, 54) et/ou les deuxièmes parties de stabilisation (51, 53) présentent une grande surface.

3. Dispositif selon la revendication 2, dans lequel les premières parties de stabilisation (50, 54) et/ou les deuxièmes parties de stabilisation (51, 53) présentent plusieurs lamelles.

4. Dispositif selon l'une des revendications précédentes, dans lequel les parties de stabilisation (50-54) sont enterrées dans la première couche (3).

5. Dispositif selon l'une des revendications 1 à 3 qui précèdent, dans lequel les parties de stabilisation (50-54) sont reliées directement à un troisième contact sur lequel la deuxième polarité (Gnd) de l'alimentation en tension est appliquée.

6. Dispositif selon l'une des revendications précédentes, dans lequel les parties de stabilisation (50-54) présentent une haute concentration en matériau de dopage.

7. Dispositif selon l'une des revendications précédentes, dans lequel la première polarité de l'alimentation en tension (V_{DD}) présente un potentiel positif par rapport à la deuxième polarité (Gnd).
